Europäisches Patentamt

European Patent Office

Office européen des brevets

(19)

(11) Numéro de publication: **0 404 636**

**A1**

## (12) DEMANDE DE BREVET EUROPEEN

(21) Numéro de dépôt: **90401619.3**

(22) Date de dépôt: **12.06.90**

(51) Int. Cl.5: **H03K 19/0185**

(30) Priorité: **23.06.89 FR 8908385**

(43) Date de publication de la demande:
**27.12.90 Bulletin 90/52**

(84) Etats contractants désignés:
**DE GB NL**

(71) Demandeur: **THOMSON COMPOSANTS MICROONDES**
**51. Esplanade du Général de Gaulle**
**F-92800 Puteaux(FR)**

(72) Inventeur: **Dankaert, Jean-Yves**
**THOMSON-CSF SCPI Cédex 67**
**F-92045 Paris la Défense(FR)**
Inventeur: **Perea, Ernesto**
**THOMSON-CSF SCPI Cédex 67**
**F-92045 Paris la Défense(FR)**

(74) Mandataire: **Taboureau, James et al**
**THOMSON-CSF SCPI**
**F-92045 Paris La Défense Cédex 67(FR)**

(54) **Circuit d'interface de sortie entre deux circuit numériques de natures différentes.**

(57) Cette interface constitue une adaptation des signaux de sorties d'un premier circuit, par exemple en GaAs, au gabarit des signaux d'entrées dans un second circuit numérique, par exemple en silicum.

Il comprend un amplificateur de courant (1 à 4) qui reçoit le signal de sortie du circuit GaAs. Les tensions au niveau haut sont contrôlées par une diode (6) en série avec un transistor (5) qui est alors passant. Au niveau bas, le transistor (5) est bloqué, et ce sont deux diodes (7,8), en parallèle avec le transistor (5), qui contrôlent la tension de sortie.

Cette interface est intégrée sur la puce du circuit numérique, en GaAS.

La présente invention concerne un circuit électronique qui constitue une interface de sortie permettant la compatibilité de circuits de type BFL par exemple, réalisés sur GaAS ou matériau III-V avec des circuits de type ECL réalisés sur silicium. Ce circuit d'interface est lui-même réalisé en GaAs et intégré sur la puce du circuit de type BFL pour laquelle il constitue un plot de sortie.

On sait que le traitement des signaux hyperfréquences fait appel à des circuits numériques sur GaAs - ou d'autres matériaux rapides, mais GaAs est le plus courant - et à des circuits numériques sur silicium. Les circuits sur GaAs sont plus rapides, et permettent d'atteindre des fréquences que n'atteignent pas les circuits sur silicium, mais ceux-ci sont, dans l'état actuel de la technologie, plus développés et plus intégrés que les circuits GaAs. Il y a donc complémentarité, mais les niveaux de sortie, en tensions, des circuits GaAs ne sont pas directement adaptés aux niveaux d'entrée des circuits silicium. C'est pourquoi une interface est nécessaire.

Pour illustrer l'invention, supposons que le circuit GaAs comprend en sortie une porte BFL (Buffered FET Logic) bien connue, alimentée par exemple entre $V_{dd}$ = O V, $V_{ss}$ = - 5,5 V et avec une tension d'intermédiaire $V_{rr}$ = -3 V. Pour une telle porte, les niveaux logiques en entrées et en sortie sont de l'ordre : $V_{haut}$ = -2,5 V environ et $V_{bas}$ = -4,5 V environ, bien que les niveaux de sortie puissent être décalés au moyen d'une ou plusieurs diodes de décalage, selon les tensions d'alimentations choisies.

Cependant, le gabarit des circuits silicium de type ECL est :
- niveau de sortie haut : -1,03 < $V_{oh}$ < - 0,88
- niveau de sortie bas : -1,83 < $V_{ol}$ < - 1,62
- niveau d'entrée haut : - 1,1 < $V_{ih}$
- niveau d'entrée bas : $V_{il}$ < - 1,5

L'interface de sortie selon l'invention permet de résoudre ce problème de différences entre les tensions de sorties des circuits GaAs et les tensions requises en entrée d'un circuit silicium.

Selon l'invention, le niveau de sortie des signaux issus du circuit GaAS est contrôlé par des diodes, le courant, et par conséquent la tension, étant fixé par la résistance de charge extérieure au circuit. Cette interface comprend ainsi trois étages : un étage d'adaptation et d'amplification, un étage de contrôle du niveau haut et un étage de contrôle du niveau bas.

De façon plus précise, l'invention concerne un circuit d'interface de sortie, destiné à adapter les tensions de sortie d'un premier circuit numérique sur GaAs ou matériaux du groupe III-V au gabarit d'entrée d'un second circuit numérique sur silicium, de type ECL, caractérisé en ce qu'il comporte :

- un amplificateur de tension et de courant, qui reçoit sur la grille de son transistor d'entrée le signal issu de la sortie du circuit GaAs,
- un étage de contrôle du niveau haut de la tension de sortie, formé par une diode (6) en série avec un transistor interrupteur, dont la grille reçoit le signal issu de l'amplificateur de courant, et dont la source est réunie à la sortie de l'interface, vers le circuit silicium,
- un étage de contrôle du niveau bas de la tension de sortie, formé par deux diodes en série, montées en parallèle avec l'étage de contrôle du niveau haut, ces deux étages étant alimentés entre une tension $V_{dd}$ = O V appliquée sur les diodes et une tension de rappel $V_{TT}$ = - 2 V.

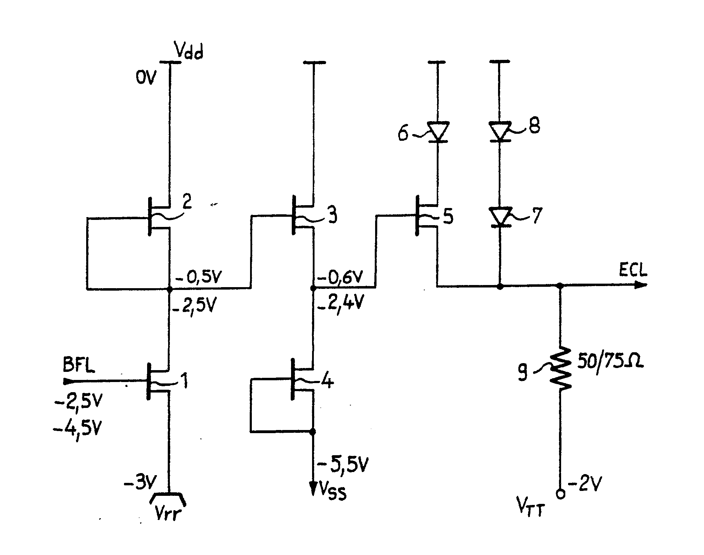

L'invention sera mieux comprise par la description plus détaillée qui suit d'un exemple d'application, dont le schéma électrique est représenté en figure unique.

L'interface de sortie d'un circuit en GaAs vers un circuit en silicium de type ECL a deux fonctions principales :
- assurer la compatibilité des niveaux de tensions, en sortie de la pastille de GaAs, avec le gabarit d'entrée de la pastille en silicium,
- permettre l'utilisation de lignes adaptées normalisées, de faible impédance : 50 ou 75 ohms.

Pour que le circuit intégré GaAs, muni d'une ou plusieurs interfaces selon l'invention, soit interchangeable avec un circuit ECL sur silicium, et pour conserver les marges de bruit, on impose à l'interface de sortie un gabarit qui est le même que celui d'un circuit ECL, soit :
- 0,85 > $V_{oh}$ > - 1 V
- 1,6 > $V_{ol}$ > - 1,8 V

Les niveaux de sorties d'un circuit de type BFL sur GaAs étant compris entre - 4,5 et - 2,5 V, il suffit de les contrôler pour les amener dans une fourchette de -1,8 à - 0,85 V. Le fondement de l'invention est de contrôler le niveau de sortie du circuit GaAs non pas par des transistors, mais par des diodes : le courant de sortie, donc la tension, est alors fixé par la résistance de charge extérieure au circuit GaAs.

Le circuit d'interface selon l'invention, représenté en figure unique, comprend d'abord un étage amplificateur de courant. La tension de sortie du circuit GaAs, non représenté mais symbolisé par BFL, est appliquée sur la grille d'un transistor 1, alimenté par le transistor 2 monté en source de courant : ces deux transistors sont réunis à des tensions d'alimentation $V_{dd}$ = O V et $V_{rr}$ = - 3 V, par exemple. Si la tension d'entrée varie entre - 2,5 et - 4,5 V, la tension de sortie, sur le drain du transistor 1, varie entre - 0,5 et - 2,5 V. Elle est appliquée sur la grille du transistor 3, alimenté par le transistor 4 monté en source de courant : ces deux transistors sont réunis à des tensions d'alimentation $V_{dd}$ = O V et $V_{ss}$ = - 5,5 V, par exemple. Les tensions citées peuvent bien entendu être différentes, selon la technologie utilisée. La tension de sortie sur la source du transistor 3, varie entre -0,6 V (niveau haut) et - 2,6 V (niveau bas).

Le rôle de cet amplificateur est de fournir un courant suffisant pour charger la capacité parasite du transistor 5, dans l'étage suivant qui commande le niveau haut en sortie.

Celui-ci est composé d'une diode 6, dont l'anode est à $V_{dd}$, en série avec le transistor 5, qui est de très grandes dimensions. A titre d'exemple, alors que les transistors 1 à 4 ont des largeurs de l'ordre de 10 à 40 microns, le transistor 5 a une largeur de l'ordre de 500 microns. Cela lui permet de fonctionner en linéaire et d'avoir une chute de tension minimale : $V_{DS}$ = 50 mV, il fonctionne en interrupteur presque parfait.

Le niveau haut est alors contrôlé par la diode 6, qui est elle aussi très grande (300 microns) et présente une chute de tension de l'ordre de 800 mV. Selon la valeur de la tension d'entrée, la tension de sortie, limitée par la seule diode 6, est comprise entre - 0,9 et - 1 V, c'est à dire qu'elle est dans le gabarit de sortie d'un circuit ECL sur silicium.

Lorsque le signal de sortie du circuit GaAs est à son niveau bas (- 4,5 V), le transistor 5 est bloqué. Le niveau bas est alors contrôlé par des deux diodes 7 et 8, alimentées à partir de $V_{dd}$ = O V. En passant en direct, elles empêchent la tension de sortie de descendre en dessous de - 1,8 V. En effet, la charge de sortie, symbolisée par une résistance 9 de 50 ou 75 ohms, est réunie à une tension de rappel $V_{TT}$ de l'ordre de - 2 V. Les diodes 7 et 8, de dimensions normales de l'ordre de 30 microns, ont chacune une chute de tension $V_d$ = 900 $m_V$, soit 1,8 V pour les deux diodes.

Comme cela a été déjà précisé, cette interface est réalisée directement sur la pastille d'un circuit intégré en GaAs, et connectées à ses sorties : le circuit GaAs devient alors interchangeable avec un circuit silicium ECL puisqu'il a le même gabarit de sortie mais il travaille plus vite.

L'interface sortie selon l'invention est précisée par les revendications suivantes.

## Revendications

1 - Circuit d'interface de sortie, destiné à adapter les tensions de sortie d'un premier circuit numérique sur GaAs où matériaux du groupe III-V au gabarit d'entrée d'un second circuit numérique sur silicium, de type ECL, caractérisé en ce qu'il comporte :
- un amplificateur de courant (1 à 4) , qui reçoit sur la grille de son transistor d'entrée (1) le signal issu de la sortie du circuit GaAs.
- un étage de contrôle du niveau haut de la tension de sortie, formé par une diode (6) en série avec un transistor interrupteur (5), dont la grille reçoit le signal issu de l'amplificateur de courant (1 à 4), et dont la source est réunie à la sortie de l'interface, vers le circuit silicium,
- un étage de contrôle du niveau bas de la tension de sortie, formé par deux diodes (7,8) en série, montées en parallèle avec l'étage de contrôle du niveau haut (5,6), ces deux étages étant alimentés entre une tension $V_{dd}$ = O V appliquée sur les diodes (6,8) et une tension de rappel $V_{tt}$ = - 2 V.

2 - Circuit d'interface selon la revendication 1, caractérisé en ce que le transistor interrupteur (5) est de grandes dimensions de façon à avoir une faible chute de tension entre drain et source, le niveau haut de la tension de sortie étant contrôlé par la chute de tension dans la diode (6) en série avec ledit transitor (5).

3 - Circuit d'interface selon la revendication 1, caractérisé en ce que, pour une tension d'entrée à l'état bas, le transistor interrupteur (5) est bloqué, le niveau bas de la tension de sortie étant contrôlé par la chute de tension dans les deux diodes (7,8) en parallèle avec ledit transistor (5).

4 - Circuit d'interface selon l'une quelconque des revendications 1 à 3, caractérisé en ce qu'il est intégré sur la puce du circuit numérique en GaAs, et constitue une adaptation en plots de sorties.

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | US-A-4 410 815 (S.A. RANSOM et al.)<br>* figure 1; abrégé *<br>--- | 1,4 | H 03 K 19/0185 |
| A | EP-A-0 085 569 (SPERRY CORP.)<br>* figure 5; page 6, ligne 17 - page 7, ligne 33; revendication 1,3,4 *<br>--- | 1,4 | |
| A | EP-A-0 131 952 (SIEMENS AG)<br>* figure 3; abrégé *<br>--- | 1,4 | |
| A | PATENT ABSTRACTS OF JAPAN<br>vol. 11, no. 20 (E-472)(2467), 20 janvier 1987; & JP-A-61192123 (FUJITSU LIMITED) 26.08.1986<br>--- | 1,4 | |
| A | PATENT ABSTRACTS OF JAPAN<br>vol. 9, no. 110 (E-314)(1833), 15 mai 1985; & JP-A-601922 (NIPPON DENSHIN DENWA KOSHA) 08.01.1985<br>--- | 1,4 | |
| A | IEEE PROCEEDINGS OF THE GALLIUM ARSENIDE INTEGRATED CIRCUIT SYMPOSIUM 9-11 novembre 1982, pages 17-20, New York, US; D. KINELL: "A 320 Gate GaAs Logic Gate Array" * figure 4 *<br>----- | 1,4 | **DOMAINES TECHNIQUES RECHERCHES (Int. Cl.5)**<br><br>H 03 K 19/0185<br>H 03 K 19/094 |

Le présent rapport a été établi pour toutes les revendications

| Lieu de la recherche | Date d'achèvement de la recherche | Examinateur |
|---|---|---|
| BERLIN | 25-07-1990 | ARENDT M |